# FASCICULE DE BREVET EUROPEEN

(11) **EP 3 195 428 B1**
(45) Date de publication et mention de la délivrance du brevet: **22.07.2020**
(21) Numéro de dépôt: 15775115.7
(22) Date de dépôt: 15.09.2015
(51) Int. Cl.: H01S 3/08, H01S 5/00, H01S 5/10, H01S 5/14, H01S 5/183, H01S 5/04

(54) **DISPOSITIF LASER A CAVITE EXTERNE VERTICALE A EMISSION PAR LA SURFACE A DOUBLE FREQUENCES, POUR LA GENERATION DE THZ ET PROCEDE DE GENERATION DE THZ.**
DOPPELFREQUENZ-OBERFLÄCHENEMISSIONSLASERVORRICHTUNG ZUR ERZEUGUNG VON THZ UND VERFAHREN ZUR ERZEUGUNG VON THZ
DUAL-FREQUENCY VERTICAL-EXTERNAL-CAVITY SURFACE-EMITTING LASER DEVICE FOR GENERATING THZ AND METHOD FOR GENERATING THZ

(30) Priorité: 15.09.2014 FR 1402058
(43) Date de publication de la demande: 26.07.2017
(73) Titulaire: Université de Montpellier, 34090 Montpellier (FR); Centre National de la Recherche Scientifique, 75016 Paris (FR)
(72) Inventeur: GARNACHE-CREUILLOT, Arnaud, 34000 Montpellier (FR); MYARA, Mikhael, 34200 SÈTE (FR); BLIN, Stéphane, 34570 Murviel Les Montpellier (FR); SAGNES, Isabelle, 75015 Paris (FR); BEAUDOIN, Grégoire, 94100 Saint-Maur-des-Fossés (FR); SELLAHI, Mohamed, 34090 Montpellier (FR); PAQUET, Romain, 66370 Pezilla-la-Rivière (FR)
(74) Mandataire: IPAZ
(86) Numéro de dépôt international: PCT/EP2015/071139
(87) Numéro de publication internationale: WO 2016/041993

(56) Documents cités:
- US-A1- 2002 071 463
- US-A1- 2012 063 481
- US-B1- 6 711 203
- SELLAHI MOHAMED ET AL: "Generation of new spatial and temporal coherent states using VECSEL technology: VORTEX, high order Laguerre-Gauss mode, continuum source", PROCEEDINGS OF SPIE, S P I E - INTERNATIONAL SOCIETY FOR OPTICAL ENGINEERING, US, vol. 8966, 3 mars 2014 (2014-03-03), pages 89660U-89660U, XP060034401, ISSN: 0277-786X, DOI: 10.1117/12.2040468 ISBN: 978-1-62841-839-2
- PAQUET R ET AL: "Vertical-external-cavity surface-emitting laser for THz generation", 2014 39TH INTERNATIONAL CONFERENCE ON INFRARED, MILLIMETER, AND TERAHERTZ WAVES (IRMMW-THZ), IEEE, 14 septembre 2014 (2014-09-14), pages 1-2, XP032683366, DOI: 10.1109/IRMMW-THZ.2014.6956480
- JESSICA BARRIENTOS ET AL: "Dual-frequency operation of a vertical external cavity semiconductor laser for coherent population trapping cesium atomic clocks", LASERS AND ELECTRO-OPTICS EUROPE (CLEO EUROPE/EQEC), 2011 CONFERENCE ON AND 12TH EUROPEAN QUANTUM ELECTRONICS CONFERENCE, IEEE, 22 mai 2011 (2011-05-22), page 1, XP031954520, DOI: 10.1109/CLEOE.2011.5942630 ISBN: 978-1-4577-0533-5
- M. WICHMANN ET AL: "Systematic investigation of single- and multi-mode operation in vertical-external-cavity surface-emitting lasers", PROCEEDINGS OF SPIE, vol. 8966, 3 mars 2014 (2014-03-03), page 89660N, XP055230990, US ISSN: 0277-786X, DOI: 10.1117/12.2037871 ISBN: 978-1-62841-839-2
- BAILI G ET AL: "Experimental demonstration of a turnable dual-frequency semiconductor laser free of relaxation oscillations", OPTICS LETTERS, OPTICAL SOCIETY OF AMERICA, US, vol. 34, no. 21, 1 novembre 2009 (2009-11-01), pages 3421-3423, XP001549427, ISSN: 0146-9592, DOI: 10.1364/OL.34.003421

## Description

### Domaine de l'invention

La présente invention concerne des dispositifs laser à cavité externe verticale à émission par la surface (VeCSEL pour « Vertical External Cavity Surface Emitting Laser »), et plus spécifiquement la génération de deux modes transverses stabilisés avec de tels dispositifs.

Le domaine de l'invention est, sans s'y limiter, celui des sources térahertz (THz) de laser à semi-conducteur ainsi que leurs applications.

### Contexte de l'invention

Les ondes THz couvrent le spectre électromagnétique compris entre les micro-ondes et l'infrarouge. Le domaine d'application est très large avec quelques applications prometteuses, comme par exemple en astronomie, dans les systèmes radars, en métrologie temps-fréquence, dans la détection et l'imagerie biomédicales, dans les communications sans fil à haut débit ou encore dans la sécurité. Il existe une grande variété de solutions pour l'émission THz, allant de l'optique à l'électronique, mais les solutions existantes sont souvent fastidieuses ou limitées en termes de puissance de sortie, de cohérence, d'accordabilité et/ou de modulation la bande passante : dans la gamme supérieure du spectre THz, les sources sont généralement de type pulsées et/ou requièrent un fonctionnement à basse température ; et dans la gamme inférieure du spectre THz, les sources électroniques fonctionnent habituellement facilement à température ambiante en continu et à une fréquence d'émission déterminée. De surcroît, des sources à fréquence multiples offrent une accordabilité accrue mais ne fournissent pas simultanément à la fois une puissance de sortie suffisante et une modulation de bande passante importante, mais aussi une bonne compacité ou un coût raisonnable.

Différentes techniques sont mises en œuvre pour générer des ondes THz, distinguables selon deux catégories :
- la première catégorie consiste en un couplage photonique d'une configuration à deux sources lasers et au travers de laquelle la différence de fréquence entre les deux sources est largement accordable. Par ailleurs, comme deux sources distinctes sont utilisées, cette première technique sera sensible aux effets de dérive de chacune des sources et la fréquence de battement n'est pas très stable ;
- la seconde catégorie consiste en un laser à deux modes : dans ce cas, la différence de fréquence est intrinsèquement plus stable car les deux modes seront sensibles à des effets communs et les effets de dérives seront homogènes sur chacun des deux modes.

De nombreuses tentatives bien connues pour parvenir à des sources laser térahertz double fréquences compactes, stables, continument accordables, cohérentes et puissantes ont déjà été proposées, mais aucune n'a pleinement rempli ces exigences.

L'une d'entre elle permet de réduire le couplage de mode et consiste en une séparation des faisceaux laser à l'intérieur d'une même cavité à deux axes. Elle présente des résultats très positifs en termes d'accordabilité et de cohérence. Toutefois, l'accordabilité se fait de manière incrémentale, la puissance de sortie est limitée à quelques milliwatts, la cavité est sophistiquée et comprend des éléments mobiles intracavité qu'il est presque impossible d'intégrer sur un seul dispositif, et la cohérence d'une telle source est dégradée.

Une autre technique consiste en une diode laser à cavités externes utilisant un (des) filtre(s) spectral (spectraux) qui peuvent produire deux fréquences stables, mais au détriment de la puissance de sortie, de cavités complexes , de la sensibilité/robustesse d'alignement dégradées, de la qualité de faisceau et de sa cohérence car le laser tend à exploiter deux jeux de modes longitudinaux plutôt que deux modes.

Les dispositifs laser à cavité externe verticale à émission par la surface (VeCSEL) sont des dispositifs bien connus et sont des solutions très prometteuses pour les lasers double fréquence car ils sont intrinsèquement compacts, flexibles en longueur d'onde, accordable sur un large spectre, puissants et hautement cohérents (spectralement, spatialement et également en termes de polarisation).

Le fonctionnement de laser double fréquence basé sur la coexistence de deux modes longitudinaux de génération de THz dans un VeCSEL a déjà été décrit dans M. Wichmann et al. « Systematic investigation of single and multi-mode operation in vertical-external-cavity surface-emitting lasers » Proc. SPIE 89660N*,* mais une telle conception ne permet pas le fonctionnement simultané des deux lignes laser.

Une autre démonstration de VeCSEL est décrite dans Gaya Baili et al., « Expérimental demonstration of a tunable dual-frequency semiconductor laser free of relaxation oscillations », Optics Letters, Vol. 34, Issue 21, pages 3421 à 3423 (2009*).* Elle traite de l'utilisation d'un VeCSEL dans la gamme du GHz et est basée sur un faisceau à double polarisation avec division de faisceau intracavité sur la puce amplificatrice.

On connait des documents SELLAHI MOHAMED ET AL: « Generation of new spatial and temporal coherent states using VECSEL technology: VORTEX, high order Laguerre-Gauss mode, continuum source », PROCEEDINGS OF SPIE, SPIE - INTERNATIONAL SOCIETY FOR OPTICAL ENGINEERING, US, vol. 8966, 3 mars 2014 (2014-03-03), pages 89660U-89660U; PAQUET R ET AL:
« Vertical-external-cavity surface-emitting laser for THz generation », 2014 39TH INTERNATIONAL CONFERENCE ON INFRARED, MILLIMETER, AND TERAHERTZ WAVES (IRMMW-THZ), IEEE, 14 septembre 2014 (2014-09-14), pages 1-2;
JESSICA BARRIENTOS ET AL: « Dual-frequency operation of a vertical external cavity semiconductor laser for coherent population trapping cesium atomic clocks » LASERS AND ELECTRO-OPTICS EUROPE (CLEO EUROPE/EQEC), 2011 CONFERENCE ON AND 12TH EUROPEAN QUANTUM ELECTRONICS CONFERENCE, IEEE, 22 mai 2011 (2011-05-22), page 1;
et M. WICHMANN ET AL: « Systematic investigation of single- and multi-mode operation in vertical-external-cavity surface-emitting lasers» PROCEEDINGS OF SPIE, vol. 8966, 3 mars 2014 (2014-03-03), page 89660N divulguant un dispositif laser de génération d'une onde optique selon le préambule de la revendication 1.

Le but de la présente invention est de répondre aux problèmes mentionnés précédemment et de conduire par ailleurs à d'autres avantages.

Un objectif de l'invention consiste à générer un effet laser à deux modes transverses, stables et robustes/maîtrisés au sein d'une seule cavité.

Un autre objectif de la présente invention consiste à proposer des sources laser présentant une très haute stabilité (c'est-à-dire une haute cohérence ou un faible bruit de phase) de la fréquence de battement.

Un autre objectif de la présente invention consiste à proposer des sources laser adaptés pour des fonctionnements à haute puissance avec une bonne cohérence et une bonne stabilité.

Un autre objectif de l'invention consiste à proposer des sources laser disposant d'une accordabilité continue ou fine sur une large gamme de fréquences.

Un autre objectif de l'invention consiste à proposer des sources laser compactes fonctionnant à température ambiante en mode continu.

### Résumé de l'invention

On atteint ces objectifs grâce à un dispositif laser de génération d'une onde optique selon la revendication 1.

Selon l'invention, les moyens de mise en forme de l'intensité lumineuse comprennent au moins un masque, chaque masque étant agencé avec une surface ayant une absorbance non uniforme, ladite surface incluant au moins une zone d'absorption et/ou au moins une zone de transmission ; les moyens de mise en forme du profil de phase de l'onde optique sont agencés pour régler les au moins deux modes transverses de l'onde optique, et comprennent notamment au moins un cristal photonique et/ou un réseau de diffraction situés à au moins une extrémité de la région de gain et agencés pour mettre en forme la phase transversale et/ou l'intensité transversale de l'onde optique, pour sélectionner au moins deux modes transverses.

En variante, la région de gain (quelconque) peut être un élément distinct du second miroir.

D'une manière plus générale, le nombre de fréquences stabilisées émises par le laser selon l'invention correspond au nombre de modes transverses sélectionnés.

Dans certains modes de réalisation de l'invention, les moyens de pompage de la région de gain peuvent inclure des moyens optiques et électriques. Le premier élément peut être un élément semi-conducteur de type demi-VCSEL, ou tout autre type de laser dans lequel les modes transverses peuvent résonner à l'intérieur de la cavité. Le dispositif laser selon la présente invention tire profit des structures VeCSEL en termes de puissance de sortie, stabilité et robustesse. De plus, l'utilisation d'un demi-VCSEL permet d'utiliser le dispositif laser selon la présente invention à température ambiante et dans un mode continu, ce qui simplifie grandement son utilisation et le rend plus polyvalent. Les qualités optiques intrinsèques de la cavité sont très bonnes et conviennent tout particulièrement à de telles applications : les pertes optiques sont faibles et il n'y a pas d'émission spontanée amplifiée, ce qui conduit à une onde hautement cohérente. Enfin, il n'y a pas de comportement dynamique complexe et non linéaire ; et la fréquence peut être continument accordée sur une très large gamme de fréquences car il n'y a pas de couplage de gain et pas de couplage de mode dans la cavité. Ainsi, il est possible de générer un laser double fréquence hautement cohérent et basé sur la stabilisation de deux modes transverses dans la cavité à axe unique de VeCSEL.
de manière plus particulière, les au moins deux modes transverses sélectionnés de l'onde optique selon la présente invention peuvent être choisis entre (i) les modes de Laguerre-Gauss stabilisés, et/ou (ii) les modes d'Hermite-Gauss stabilisés et/ou (iii) les modes de Bessel-Gauss stabilisés ou tout autre état d'émission laser : d'autres bases de mode transverses de la cavité (états propres de lumière) - ou modes instables de la cavité - peuvent être utilisés, à condition d'être générés simultanément.

D'une manière générale, les moyens de filtrage spatial de l'onde optique peuvent être choisis entre (i) des moyens de diffraction de la lumière, (ii) des moyens de diffusion de la lumière et (iii) des moyens d'absorption de la lumière. Dans d'autres modes de réalisation de la présente invention, les moyens de filtrage spatial de l'onde optique peuvent être situés au niveau d'un ventre du champ longitudinal stationnaire à l'intérieur de la cavité.

Dans un mode de réalisation préféré, les moyens d'absorption de la lumière peuvent comprendre un seul masque, ledit masque étant agencé pour sélectionner les au moins deux modes transverses de l'onde optique.

Comme cela sera décrit ci-après, les moyens d'absorption ou de diffraction de la lumière précédemment mentionnés peuvent être intégrés sur l'élément semi-conducteur. Ainsi, aucun alignement n'est nécessaire et aucun bruit mécanique ne peut être introduit par des vibrations. Ainsi, la présente invention permet de stabiliser des modes résonants à l'intérieur de la cavité en sélectionnant ces modes transverses isolés et en empêchant le couplage avec certains modes non souhaités : la source laser selon l'invention fournit une fréquence de battement très stable.

Dans un autre mode de réalisation préféré, l'épaisseur de chaque masque peut être de l'ordre de quelques nanomètres ou inférieur à la longueur d'onde.

Dans un autre mode de réalisation préféré, la zone d'absorption fournit une absorbance au moins deux fois plus élevée que l'absorbance de la zone de transmission. Dans certains autres modes de réalisation, les zones de transmission peuvent transmettre plus de 99 % de l'intensité lumineuse de l'onde, et les zones d'absorption peuvent absorber entre 5 % et 100 % de l'intensité lumineuse de l'onde.

Dans un autre mode de réalisation préféré, chaque masque peut être situé au niveau d'un ventre de l'onde optique à l'intérieur de la cavité, ou proche dudit ventre.

Selon l'invention, le moyen de mise en forme du profil de phase longitudinale présente une distribution transverse non uniforme du gain à l'intérieur de la cavité optique, afin de moduler transversalement l'intensité de la longueur d'onde d'émission du gain et de régler l'écart en fréquence entre les au moins deux modes transverses de l'onde optique.

Particulièrement, le moyen de mise en forme du profil de phase longitudinal peut comprendre en outre au moins un masque de pertes non uniforme transversalement entre les deux modes afin d'ajuster l'écart en fréquence entre les deux modes en ajustant localement les porteurs injectés dans les zones du gain pour modifier la longueur d'émission du gain sur ces zones.

Eventuellement, le réglage fin des modes transverses oscillants à l'intérieur de la cavité peut être obtenu à l'aide d'un moyen de mise en forme du profil de phase comprenant une source de chaleur agencée pour générer à l'intérieure de la cavité optique une distribution transverse non uniforme de température, afin de déterminer et contrôler l'écart en fréquence entre les au moins deux modes transverses de l'onde optique.

De manière préférentielle, alternativement ou complémentairement, le moyen de mise en forme du profil de phase comprend un filtre spectral présentant une longueur optique non uniforme le long de sa section transverse afin de régler l'écart en fréquence entre les deux modes transverses de ladite onde optique.

D'une manière générale, les moyens de mise en forme du profil de phase peuvent être agencés pour modifier l'indice de réfraction « vu » par l'onde optique et par au moins l'un des modes transverses oscillant à l'intérieur de la cavité. Comme l'indice de réfraction est, au premier ordre, sensible à la température, à la pression et à l'hygrométrie du milieu traversé par l'onde optique, un tel moyen de mise en forme du profil de phase peut consister en un moyen qui fait varier la pression et/ou l'hygrométrie et/ou la température d'au moins une partie du chemin emprunté par l'onde optique à l'intérieur de la cavité.

En l'espèce, le moyen de mise en forme du profil de phase peut comprendre un moyen de chauffage d'au moins une partie de la cavité optique, à l'aide par exemple d'une résistance électrique, placé à proximité afin de dissiper une énergie thermique par conduction et/ou convection et/ou rayonnement.

Dans le cas où le moyen de filtrage spatial comprend un réseau bidimensionnel de micro-gravures (i.e un cristal photonique), les dimensions caractéristiques, telles que le diamètre et la périodicité de leur répétition, peuvent être ajustées de manière à générer un profil transverse prédéterminé de longueur optique dudit moyen de filtrage spatial et un déphasage de chaque mode transverse oscillant dans la cavité, permettant ainsi de fixer la valeur d'un écart en fréquence entre lesdits au moins deux modes transverses.

Cette configuration permet avantageusement de définir des profils de phases quelconques en faisant varier l'une et/ou l'autre dimension caractéristique du réseau. Cette variation peut être monotone ou non monotone, et/ou continue ou discontinue : il est ainsi possible de contrôler précisément le filtrage réalisé à l'aide des variations de dimensions d'un réseau de microcavités.

Avantageusement, le filtre spectral peut comprendre aussi une moyen dynamique pour contrôler le profil transverse de la longueur optique dudit filtre spectral, tel que par exemple une matrice de pixels de cristaux liquides pilotables : il est ainsi possible de contrôler durant le fonctionnement dudit dispositif l'écart en fréquence entre les deux modes transverses afin de le faire varier et/ou de réaliser un asservissement afin de le stabiliser.

Selon un autre mode de réalisation compatible avec n'importe lequel des perfectionnements du premier aspect de l'invention, les moyens de pompage de la région de gain peuvent comprendre (i) un laser à pompe émettant un faisceau laser de pompage et (ii) des moyens agencés pour la mise en forme spatiale de l'intensité lumineuse du faisceau laser de pompage ; et les moyens de sélection d'au moins deux modes transverses de l'onde optique peuvent comprendre les moyens de mise en forme spatiale de l'intensité lumineuse du faisceau laser de pompage et peuvent être agencés pour projeter un motif d'intensité du faisceau de pompage sur la région de sortie du premier élément correspondant aux au moins deux modes transverses sélectionnés de l'onde optique.

Il est ainsi possible d'accorder le laser selon l'invention de manière à ajuster finement les au moins deux modes transverses oscillants à l'intérieur de la cavité optique ainsi que l'écart en fréquence entre lesdits au moins deux modes transverses.

Dans un autre mode de réalisation, le second miroir peut être un miroir concave ou un miroir à conjugaison de phase.

Dans un autre mode de réalisation, un filtre spectral peut être inséré à l'intérieur de la cavité, sur la surface de l'un des miroirs, ou dans l'espace libre.

Dans un mode de réalisation préféré, le dispositif laser selon l'invention peut comprendre en outre des moyens de syntonisation permettant de déplacer le second miroir de façon à changer la longueur de la cavité optique. Ainsi, il est possible d'ajuster la fréquence moyenne du laser en déplaçant le miroir externe. On pourra y parvenir à l'aide de tout moyen bien connu, tel que des actionneurs piézoélectriques par exemple, ou en ajustant la température du semi-conducteur grâce à un module de Pelletier situé au-dessus du substrat afin d'augmenter la température de manière homogène.

Dans un autre mode de réalisation, le dispositif laser selon l'invention peut comprendre en outre des moyens pour accorder la différence de fréquence entre les au moins deux modes de l'onde optique.

Dans un mode de réalisation préféré, les moyens de syntonisation de la différence de fréquence peuvent être des moyens de syntonisation thermique agencés pour établir un gradient thermique dans la direction transversale de l'élément semi-conducteur, ou préférentiellement une distribution transverse non homogène de chaleur. La syntonisation thermique est un moyen très fin de changer la température de la cavité optique (c'est-à-dire la longueur du chemin optique) et ainsi, le présent mode de réalisation de l'invention permet d'obtenir des décalages de fréquence très fins : le dispositif laser selon l'invention est ainsi continument accordable.

Dans un autre mode de réalisation préféré, les moyens de syntonisation thermique peuvent comprendre l'un des composants suivants :
- au moins un élément conducteur thermique local monté transversalement sur l'élément semi-conducteur et agencé pour conduire ou dissiper la chaleur, et/ou
- des moyens de modulation de la puissance du laser de pompage afin de chauffer, et de préférence de chauffer localement :
   - la région de sortie de l'élément semi-conducteur, et/ou
   - les moyens de filtrage spatial, et/ou
- un faisceau de pompage mis en forme qui accentue/optimise le gradient thermique ou , ou la distribution de chaleur non homogène transverse aux deux faisceaux, avec un profil d'intensité du faisceau du laser de pompage de forme semblable à un pétale par exemple.

Selon un autre aspect de l'invention, il est proposé un procédé selon la revendication 14.

Dans un mode de réalisation préféré, l'étape de sélection des au moins deux modes transverses de l'onde optique peut consister en le filtrage spatial de l'intensité de l'onde optique.

Dans un autre mode de réalisation préféré, le procédé selon l'invention peut comprendre en outre une étape consistant à accorder la longueur de la cavité optique afin de décaler les au moins deux fréquences de l'onde optique.

Dans un autre mode de réalisation préféré, le procédé selon l'invention peut comprendre en outre une étape consistant à accorder la différence de fréquence entre les au moins deux modes.

Selon un autre aspect de la présente invention, il est proposé l'utilisation du dispositif laser selon l'invention pour les techniques de génération de THz par couplage photonique, dans laquelle les au moins deux modes choisis sont injectés dans un guide d'onde.

### Description des dessins

Les procédés et dispositifs selon les modes de réalisation de la présente invention seront mieux compris en référence aux dessins, donnés à uniquement des fins d'illustration et nullement limitatifs. D'autres aspects, buts et avantages de l'invention apparaîtront dans la description donnée ci-dessous.
- La FIGURE 1 décrit une vue schématique du laser double fréquence selon l'invention.
- La FIGURE 2 est un diagramme du profil transverse de température qui pourrait être mesuré à l'intérieur de l'élément semi-conducteur.
- La FIGURE 3 est une représentation schématique de la syntonisation thermique de l'élément semi-conducteur.
- La FIGURE 4 est une vue schématique des spectres de transmission optique pour un dispositif VeCSEL double fréquence.
- La FIGURE 5 est un exemple de fichier de masquage utilisé pour fabriquer des masques selon l'invention par lithographie à faisceaux d'électrons.
- La FIGURE 6 illustre des masques métalliques absorbant en chrome selon l'invention.
- La FIGURE 7 est une vue schématique d'un dispositif laser selon l'invention avec masque métallique absorbant situé sur l'élément semi-conducteur.
- La FIGURE 8 est une vue schématique d'un dispositif laser selon un deuxième mode de réalisation de l'invention avec deux masques métalliques absorbants séparés par un espaceur situé sur l'élément semi-conducteur.
- La FIGURE 9 est une vue de l'intensité en champ lointain du dispositif laser selon l'invention.
- La FIGURE 10 est le spectre optique mesuré du dispositif laser selon l'invention.
- La FIGURE 11 est un graphique illustrant la puissance de sortie du laser en fonction de la puissance de pompage optique.
- La FIGURE 12 est un dispositif laser selon l'invention avec un masque diffractif sur l'élément semi-conducteur.
- La FIGURE 13 illustre un autre design de masque diffractif.
- La FIGURE 14 illustre le spectre THz du VeCSEL de Laguerre-Gauss double fréquence par couplage photonique et l'évolution temporelle de son intensité de mode.
- La FIGURE 15 décrit un schéma d'un filtre spectral permettant de mettre en forme le profil de phase de l'onde optique oscillant dans la cavité optique.

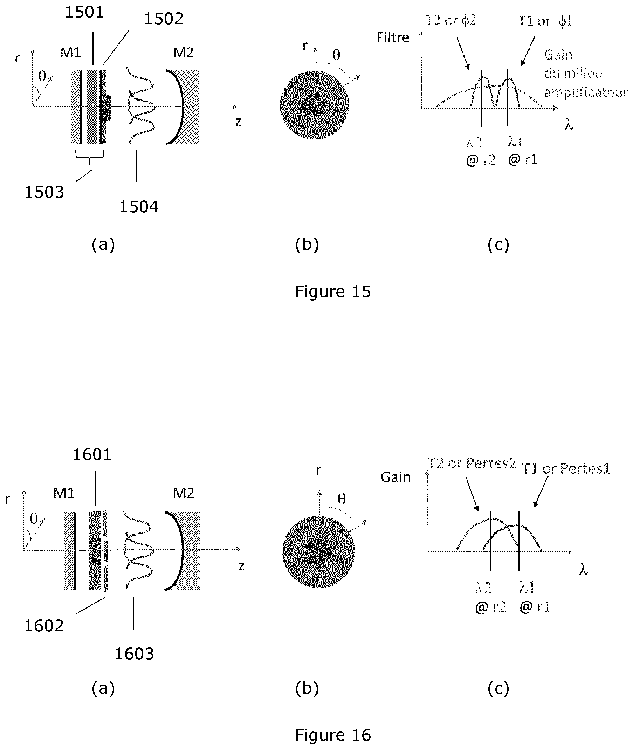

La FIGURE 16 illustre schématiquement un mode de réalisation du dispositif selon l'invention, dans lequel un milieu à gain non uniforme permet de régler l'écart de fréquence entre les deux modes transverses sélectionnés.Alors que l'invention est décrite conjointement avec un certain nombre de modes de réalisation, il est évident que de nombreuses alternatives, modifications et variations apparaissent ou apparaîtraient à l'homme du métier dans les domaines applicables. En conséquence, la présente invention prétend englober tous les alternatives, modifications, équivalents et variations qui entrent dans la portée et l'esprit de la présente invention.

### Description détaillée de l'invention

Ci-après, l'adjectif « longitudinal » se réfère à la direction qui correspond à celle de la propagation de l'onde optique 107 ou de l'axe de la cavité. L'adjectif « transversal » se réfère à une direction orthogonale à la direction longitudinale.

Dans les descriptions suivantes, le premier élément 111 est considéré comme un élément semi-conducteur, sans limiter la présente invention.

### Mode de réalisation général

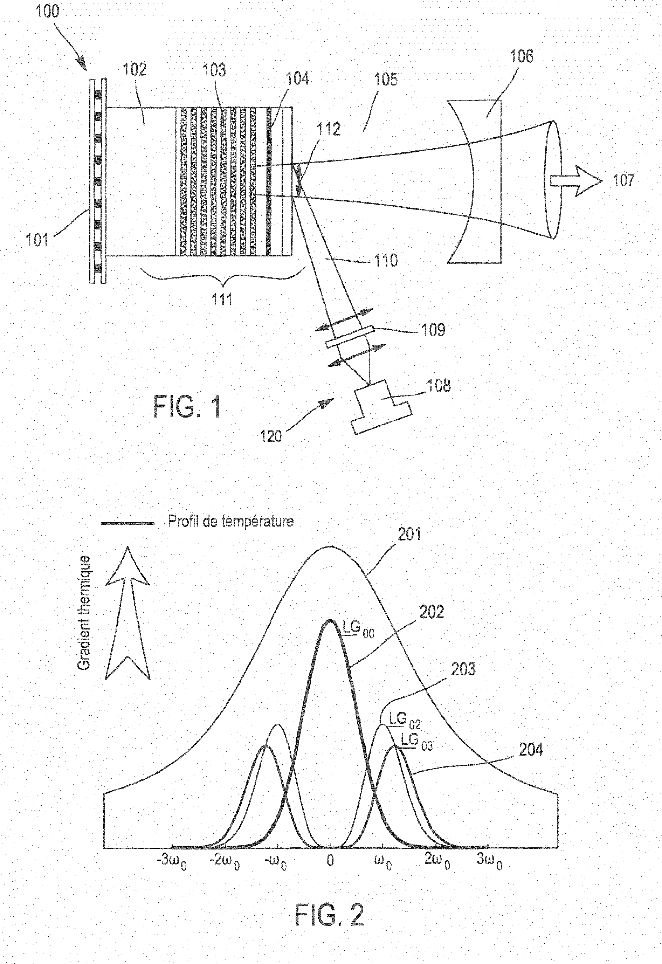

En référence à la FIGURE 1, on décrit un mode de réalisation général de la présente invention. Ce mode permet d'obtenir des modules laser stables et compacts, fonctionnant à température ambiante, avec des modes transverses bi-fréquence robustes, stabilisés et accordables.

La présente invention est basée sur une technologie VeCSEL bien connue et intègre des fonctionnalités utilisant les technologies III-V ainsi qu'une cavité optique externe de type concave.

Typiquement, la technologie VeCSEL comprend un élément semi-conducteur avec une région de gain permettant de générer un rayonnement optique et un premier miroir 103. La région de gain peut comprendre par exemple des puits quantiques et elle peut être pompée électriquement ou optiquement. Le premier miroir 103 peut comprendre une succession de couches constituant un réseau de Bragg qui réfléchit les ondes optiques 107. L'élément semi-conducteur est monté sur un dissipateur thermique à modules de Pelletier afin de stabiliser et de réguler la température.

Le tableau suivant illustre les couches constitutives du demi-VeCSEL dans un premier mode de réalisation :

| **Description** | **Epaisseur A** |
|---|---|
| Couche de coiffe InGaP | 350 |
| GaAs | 150 |
| AlAs | 300 |
| GaAs | 919 |
| GaAsP | 286 |
| PQ InGaAs | 80 |
| GaAsP | 286 |
| GaAs | 479 |
| GaAsP | 286 |
| PQ InGaAs | 80 |
| GaAsP | 286 |
| GaAs | 479 |
| GaAsP | 286 |
| PQ InGaAs | 80 |
| GaAsP | 286 |
| GaAs | 1964 |
| GaAsP | 286 |
| PQ InGaAs | 80 |
| GaAsP | 286 |
| GaAs | 1964 |
| GaAsP | 286 |
| PQ InGaAs | 80 |
| GaAsP | 286 |
| GaAs | 3449 |
| GaAsP | 286 |
| PQ InGaAs | 80 |
| GaAsP | 286 |
| GaAs | 3952 |
| AlAs | 873 |
| GaAs | 733 |
| AlAs | 873 |
| GaAs-N+ | |

De nombreuses autres configurations peuvent être développées, avec différents types de couches, de nombreux autres matériaux et d'autres largeurs. La présente invention entend couvrir toutes ces solutions.

Le miroir de Bragg a une haute réflectivité, supérieure de 99 % ou plus que celle du miroir de sortie ; par exemple, il peut être constitué de 27,5 paires de couches quart d'onde AlAs/GaAs.

La région de gain 104 est, par exemple, constituée de six puits quantiques InGaAs/GaAs(P) à contraintes compensées et situés au niveau du ventre du champ du laser intra-cavité. L'épaisseur optique totale de la région active comprise entre le réseau de Bragg et l'air est de 13/2 couches demi-onde.

Un tel élément semi-conducteur est fabriqué grâce à des technologies de fabrication de semi-conducteurs bien connues, telles que l'épitaxie par faisceau moléculaire (MBE pour « Molecular Beam Epitaxy »), la lithographie électronique, la gravure sèche et la gravure chimique.

Un second miroir externe de forme concave est prévu et agencé de façon à former une cavité optique externe avec le premier miroir 103 et à stabiliser certains modes transverses. Il faut noter que la présente invention peut être apte à stabiliser les modes de Laguerre-Gauss et/ou les modes d'Hermite-Gauss et/ou les modes de Bessel-Gauss.

La cavité optique externe est qualifiée d' « externe » car elle comprend une partie qui est distincte de l'élément semi-conducteur. Elle ne nécessite aucun composant en sus à l'intérieur pour un fonctionnement nominal du laser. Préférentiellement, sa partie externe comprend de l'air, mais dans certains autres modes de réalisation, la cavité optique du dispositif laser 100 selon l'invention peut inclure un espaceur solide entre la région de sortie et le second miroir 106 afin de former une cavité monolithique. A titre d'exemple, une telle cavité monolithique pourrait être faite d'un monolithe de saphir ou de verre.

Dans un mode de réalisation préféré, la cavité externe a une symétrie axiale.

Le second miroir 106 peut être un miroir à base de verre diélectrique ou peut comporter des cristaux photoniques sur une surface semi-conductrice ou gravée. Sa transmittance est de quelques pourcents de façon à permettre au faisceau laser de sortir du dispositif. Typiquement, le second miroir externe est situé à 1 mm de l'élément semi-conducteur, et il a un rayon de courbure d'environ 10 mm. Dans l'exemple illustré sur la FIGURE 1, un espace libre 105 sépare le miroir externe de forme concave de l'élément semi-conducteur.

Ensuite, un pompage optique est utilisé pour exciter les électrons de basse énergie vers certains niveaux plus élevés, grâce à une diode laser mono-mode. A titre d'exemple, sa longueur d'onde peut être de 785 nm et la puissance de sortie de 300 mW. Le faisceau laser de pompage 110 est focalisé sur la surface demi-VeCSEL avec un diamètre de 50 à 100 µm.

Le VeCSEL a été conçu afin de générer un état laser stable composé d'au moins deux modes transverses, chaque mode transverse fonctionnant sur un mode longitudinal unique avec un état de polarisation linéaire, et donc à une fréquence bien définie.

Les capacités de syntonisation du dispositif laser 100 selon l'invention sont détaillées ci-après.

La FIGURE 2 illustre le profil transverse de température 201 qui pourrait être mesuré à l'intérieur de l'élément semi-conducteur 111 et l'intensité de certains modes transverses de Laguerre-Gauss (LG) 202, 203 et 204. Le profil transverse de température est gaussien et les modes LG₀₀ 202, LG₀₂ 203 et LG₀₃ 204 sont représentés. La fréquence de battement entre les deux modes LG transverses repose sur un effet thermique, et plus précisément sur le gradient thermique radial 201 généré par le pompage optique (ou préférentiellement une distribution transverse non homogène de chaleur) : comme le faisceau de pompage est focalisé sur le demi-VCSEL avec un défaut de rendement quantique, un gradient thermique radial est alors généré.

Ainsi la longueur d'onde moyenne du spectre de gain du semi-conducteur est décalée de manière proportionnelle à ce gradient et selon un coefficient typiquement de 100 GHz/K. En conséquence, la différence de fréquence entre les modes transverses dépend de la distribution spatiale thermique (ou température modale) et le mode plus confiné présente la plus haute longueur d'onde de fonctionnement. La syntonisation du dispositif par la puissance de la pompe optique permet ainsi d'accorder la fréquence de battement dudit dispositif.

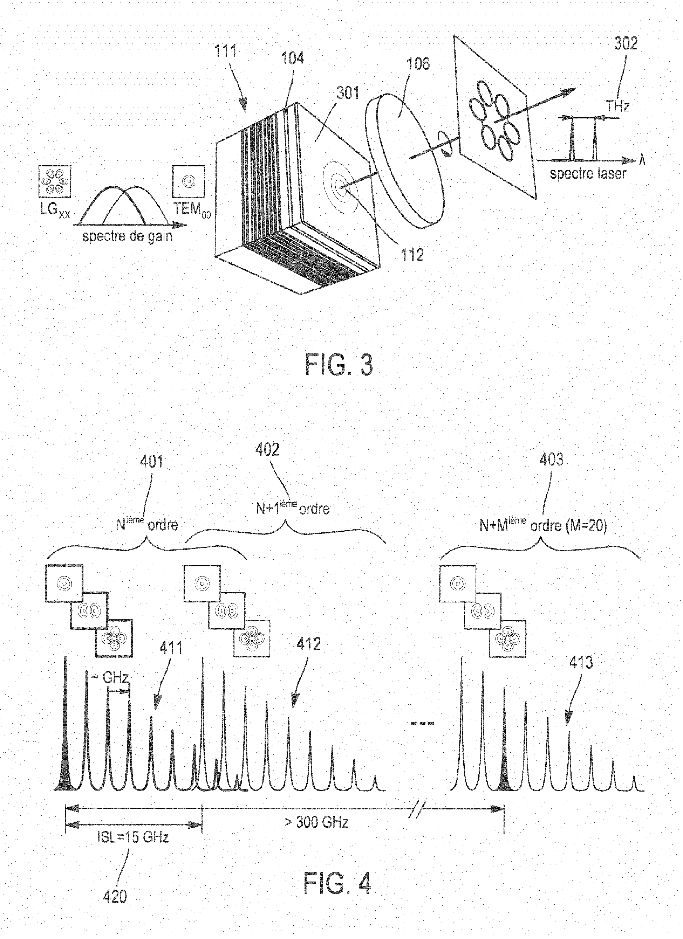

La FIGURE 3 est une représentation schématique de la syntonisation thermique sur l'élément semi-conducteur 111. Le faisceau laser de pompage 110 focalisé sur la surface de dessus 112 de l'élément semi-conducteur 111 induit un gradient thermique 301. Ainsi, l'indice de réfraction varie à l'intérieur de la cavité, et peut être différent entre deux chemins optiques axiaux (correspondant par exemple à deux modes).

Il est ainsi possible de générer plus qu'une seule fréquence 302, et il est aussi possible d'accorder la différence de fréquence entre les deux modes en modulant simplement la température de la région de gain 104. Comme la température peut être régulée de manière continue, le battement de fréquence peut ainsi être continument accordé par cette syntonisation thermique.

La syntonisation thermique peut être accomplie par tous moyens et toutes méthodes.

Dans un mode de réalisation préféré, la syntonisation thermique est assurée par le faisceau laser de pompage optique 110. En régulant la puissance du faisceau laser de pompage 110, on peut réguler la température à l'intérieur de l'élément semi-conducteur. Ainsi, il est possible de modifier localement la chaleur conduite à l'intérieur de l'élément semi-conducteur afin de réguler le gradient thermique.

Dans un autre mode de réalisation préféré, le pompage thermique peut être réalisé grâce à un dispositif de chauffage métallique local déposé sur la surface de l'élément semi-conducteur. Des couches minces métalliques sont placées transversalement afin de générer un gradient thermique lors du chauffage, ou préférentiellement une distribution transverse non homogène de chaleur.

La FIGURE 4 illustre une vue schématique des spectres de transmission optique pour un dispositif VeCSEL double fréquence. En raison de leurs caractéristiques intrinsèques, les modes transverses ont des fréquences de résonance différentes qui sont situées dans des domaines de fréquence distincts 401, 402 et 403. Ainsi, comme illustré sur la FIGURE 4, le mode de N^{ième} ordre 401 est situé sur le côté gauche des spectres, alors que les ordres de N+1^{ième} et N+M^{ième} 402, 403 sont situés sur le côté droit. Ainsi, pour chaque ordre, les modes transverses de Laguerre-Gauss existent dans un peigne de fréquences 411, 412, 413 qui est séparé de l'ordre suivant d'une distance correspondant à environ l'intervalle spectral libre 402 plus la différence de déphasage de Gouy. Le passage entre ces peignes de fréquences peut être accompli en accordant la longueur de cavité. Néanmoins, ce type de syntonisation n'affecte pas la fréquence de battement.

Néanmoins, un tel fonctionnement n'est pas suffisant pour un fonctionnement stable à deux fréquences : un tel fonctionnement en modes transverses doit être robuste et stabilisé afin d'éviter des sauts de modes transverses et une sensibilité d'alignement. Pour y parvenir, la présente invention propose une solution originale et innovante qui consiste en des moyens de mise en forme de l'intensité lumineuse et/ou de la phase de l'onde optique 107 qui résonne à l'intérieur de la cavité optique, afin de sélectionner deux modes transverses et d'éviter l'apparition d'autres modes transverses préjudiciables.

Dans certains modes de réalisation, les moyens de mise en forme de l'intensité peuvent être des moyens de filtrage spatial de l'onde optique 107 du résonateur. Il peut s'agir par exemple d'au moins un masque situé sur ou à l'intérieur de l'élément semi-conducteur 111 - préférentiellement au niveau d'un ventre du champ de l'onde laser - et avec une forme spécifique afin de fournir des premières aires au travers desquelles l'onde optique 107 peut être transmise, et d'autres aires au travers desquelles la propagation de l'onde optique 107 peut être majoritairement interrompue. En d'autres termes, le filtre spatial transversal selon l'invention induit de fortes pertes pour des modes de cavité non souhaités et de faibles pertes pour les modes souhaités.

Il inclut tout type de dispositifs de filtrage de lumière, comme par exemple des dispositifs de diffraction, des dispositifs de diffusion et des dispositifs d'absorption. On décrira ci-après deux modes de réalisation différents de filtrage spatial. Dans un mode de réalisation préféré, ces dispositifs peuvent être fabriqués par dépôt chimique en phase vapeur par composés organométalliques (MOCVD pour « Métal Organic Chemical Vapor Déposition ») et lithographie par faisceaux d'électrons, sans que la présente invention ne soit limitée à ces procédés de fabrication.

Dans certains autres modes de réalisation, les moyens de mise en forme de l'intensité de l'onde optique 107 à l'intérieur du résonateur peuvent être un dispositif de pompage à faisceau laser dont l'intensité est profilée.

Ainsi, le dispositif laser 100 selon l'invention est stable et hautement accordable : comme la syntonisation de la fréquence de battement repose sur des effets thermiques, la capacité de syntonisation peut être ajustée dans une certaine mesure par une régulation du gradient de température à l'intérieur de l'élément semi-conducteur, par exemple par une régulation de la puissance du faisceau laser de pompage 110 et/ou certains chauffages additionnels sur l'élément semi-conducteur.

### Premier mode de réalisation : masques absorbants

Dans les descriptions suivantes, les dispositifs selon le mode de réalisation de la présente invention sont adaptés au filtrage des modes transverses de Laguerre-Gauss.

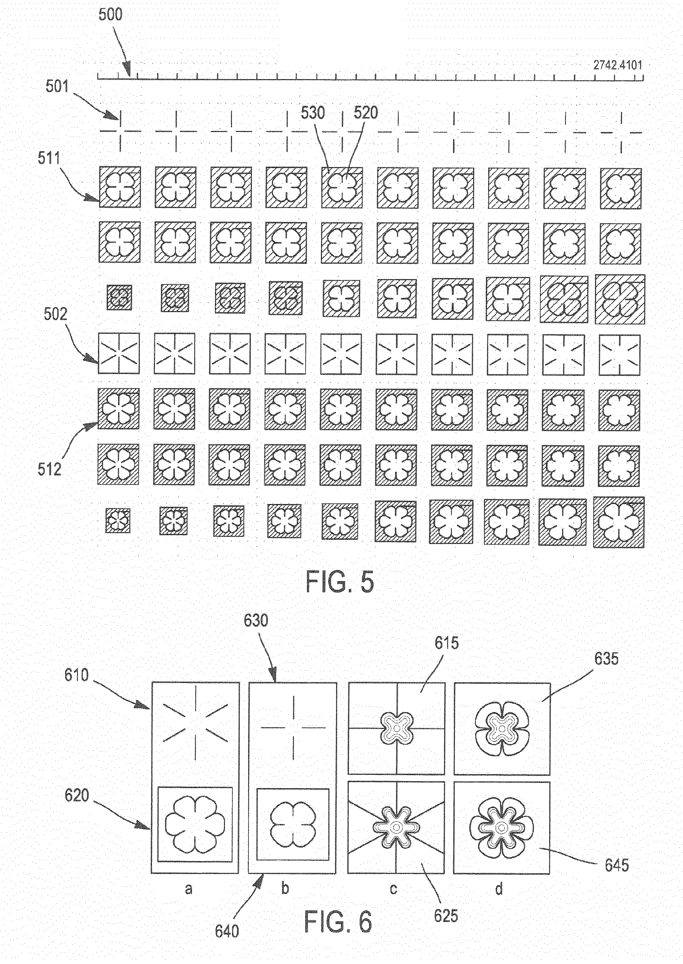

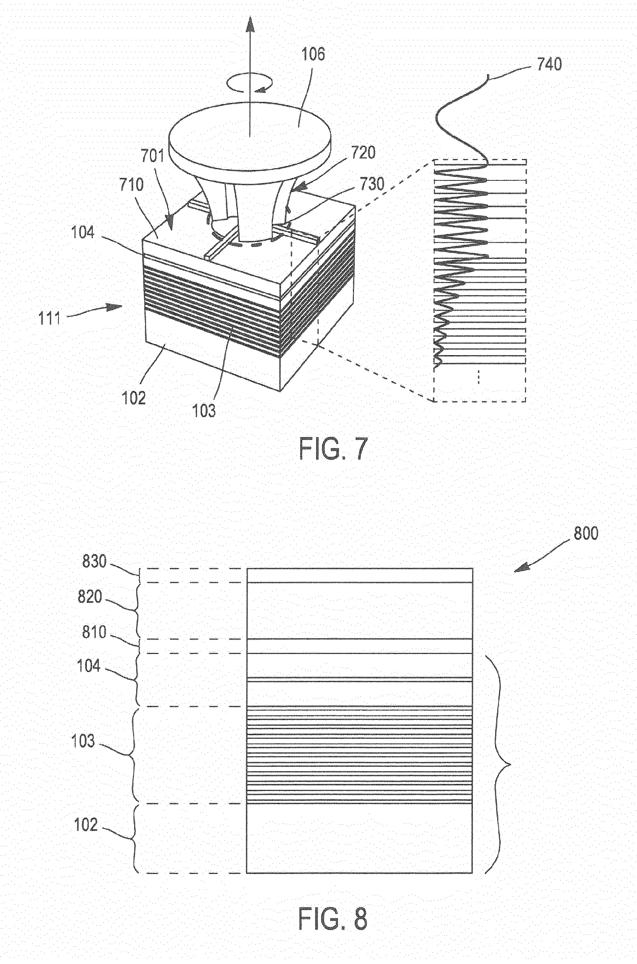

En référence à la FIGURE 5, à la FIGURE 6 et à la FIGURE 7, un filtre absorbant sub-longueur d'onde est décrit. Les dimensions globales dudit filtre sont compatibles avec l'élément semi-conducteur, car il peut être déposé sur la surface du dessus dudit élément semi-conducteur.

Dans un mode de réalisation préféré, la couche absorbante structurée peut être déposée en tout emplacement à l'intérieur de la cavité, entre le premier miroir 103 et la région de sortie.

Elle est composée d'une aire d'absorption 530 et d'une aire de transmission 520. Typiquement, l'intensité des modes transverses non souhaités de l'onde optique 107 qui résonnent à l'intérieur de la cavité peut être absorbée entre 5 % et 100 % par les aires d'absorption 530, alors que les aires de transmission 520 tendent à réduire les pertes autant que possible, et typiquement moins de 1 %.

Les formes de ces aires sont conçues afin de correspondre avec le profil transverse des modes transverses que l'on cherche à sélectionner.

La FIGURE 5 illustre un fichier de masquage utilisé pour la lithographie d'un wafer 500 destinée à concevoir le dispositif laser 100 selon la présente invention et intégrant un filtre spatial sur la surface du dessus de l'élément semi-conducteur 111. De nombreux types de motifs sont conçus sur le wafer 500 avec des caractéristiques dimensionnelles différentes. Certains d'entre eux sont plus gros que d'autres afin d'optimiser la sélection des modes transverses, en fonction de la taille du faisceau et du laser de pompage 110. De plus, il existe deux types de motifs : les premiers correspondent à des motifs simples 501, 502, constitués de lignes en forme de croix 501 ou en forme d'étoile 502, les seconds motifs sont plus sophistiqués, en forme de pétales de fleur 511, 512. Pour un type donné de filtrage de mode transverse, ces dessins sont quasiment équivalents. Ils permettent de filtrer différents ordres de modes transverses.

Par exemple, la FIGURE 6 illustre un cliché par microscope optique de masques métalliques en chrome 610, 620, 630, 640 selon l'invention ainsi que les modes transverses de Laguerre-Gauss correspondants obtenus par simulation avec de tels filtres 615, 625, 635, 645 respectivement.

Les clichés 6.a et 6.b illustrent des masques métalliques 610, 620, 630, 640 pour deux ordres de filtrage différents des modes de Laguerre-Gauss transverses. Sur les clichés 6.a et respectivement 6.b, le motif en croix 610, 630 et le motif en forme de fleur 620, 640 sont équivalents, comme on peut l'observer sur les clichés 6.c et 6.d respectivement. Plus précisément, les clichés 6.c et 6.d illustrent les modes transverses LG correspondants qui peuvent être obtenus avec ces masques absorbants : le masque 610 et 620 permet de filtrer les modes LG00+LG02 (615 et 625) alors que le masque 630 et 640 permet de filtrer les modes LG00+LG03 (635 et 645).

Pour faire fonctionner un laser en double fréquence, les masques sont conçus en fonction de certains paramètres physiques. En connaissant les paramètres optiques de la cavité, les modes de Laguerre-Gauss correspondant peuvent être calculés. Plusieurs de ces modes ne peuvent pas atteindre un fonctionnement suffisant pour l'émission laser car le faisceau de pompe gaussien est focalisé au centre de la structure, autorisant ainsi uniquement (et sélectionnant ainsi) l'existence de modes transverses de faible ordre. Pour une géométrie donnée du masque, les pertes peuvent être calculées pour chaque mode de Laguerre-Gauss et les plus faibles pertes devraient être obtenues pour les modes sélectionnés LG₀₀ et LG₀₂ par exemple. Grâce à leurs distributions transversales quasi complémentaires, ces deux modes devraient coexister en raison du brûlage de trous spatiaux transverses (« transverse spatial hole burning »).

La présente invention couvre toutes les configurations pour stabiliser/sélectionner au moins deux modes transverses : un masque peut être apte à sélectionner un, deux ou plus de deux modes transverses. Comme décrit plus bas sur la FIGURE 8, deux masques 820, 830 peuvent être combinés afin que chacun sélectionne au moins un mode transverse différent.

Typiquement, le masque est formé par le dépôt d'une couche de 10 nm de chrome et d'une largeur de quelques microns sur le demi-VeCSEL. Les caractéristiques dimensionnelles transversales sont d'environ quelques microns, en fonction du diamètre de faisceau, et, pour ce qui concerne les dimensions longitudinales, les masques doivent être suffisamment fins pour ne pas absorber des modes transverses que l'on cherche à propager à l'intérieur de la cavité. Ils doivent être suffisamment fins pour réaliser la diffraction de lumière. Une épaisseur de 10 nm est optimale pour le chrome par exemple, mais elle dépend du coefficient d'absorption du matériau choisi. D'une manière plus générale, l'épaisseur est inférieure à la longueur d'onde de l'onde optique 107 correspondante.

Ensuite, dans un mode de réalisation préféré, le masque est déposé au niveau d'un ventre de l'onde optique 107 qui oscille à l'intérieur de la cavité optique. Le matériau de dépôt n'est pas limitatif dans la présente invention. En fonction des applications, de la longueur d'onde recherchée, des technologies et/ou des performances recherchées, on pourra déposer un matériau métallique, un matériau semi-conducteur dopé, ou un matériau attaqué chimiquement et/ou un diélectrique.

La FIGURE 7 illustre la mise en œuvre d'un tel masque absorbant 710 selon l'invention, sur la surface de dessus 701 d'un demi-VeCSEL 111. Grâce aux aires d'absorption et aux aires de transmission, deux modes transverses 720, 730 sont sélectionnés et sont - finalement - stabilisés à l'intérieur de la cavité optique laser grâce au phénomène dit de brûlage de trous spatiaux transverses (« transverse spatial hole burning ») dans la région de gain 104. Ces modes oscillent entre le miroir de Bragg 103 situé à l'intérieur de l'élément semi-conducteur 111 et le second miroir concave externe 106. A la droite de la FIGURE 7, un diagramme illustre la propagation de l'intensité du champ 740 à l'intérieur de la cavité : il montre l'onde propagatrice à l'intérieur du miroir de Bragg et résonant à travers la zone active et la région de gain 104 lors d'un pompage optique.

La FIGURE 8 illustre une vue schématique d'un dispositif laser 800 selon un autre mode de réalisation de l'invention avec deux masques métalliques 820, 830. Chaque masque est déposé, l'un après l'autre. Tout d'abord, le miroir de Bragg 103 est déposé sur le substrat 102. Ensuite, la zone active avec la région de gain 104 est déposée et lithographiée sur le miroir de Bragg. Ensuite, un premier masque 810 avec un premier motif est déposé sur la surface ; dans l'exemple illustré il s'agit d'un masque en chrome dont l'épaisseur est 10 nm. Ensuite, un spaceur 820 est déposé avec une épaisseur qui dépend de la longueur d'onde. Dans l'exemple illustré, son épaisseur est égale à la moitié de la longueur d'onde. Ensuite, un second masque métallique absorbant 830 avec un second motif qui peut être différent du premier est déposé sur le spaceur.

Dans un mode de réalisation préféré, chaque masque est situé sur un ventre de l'onde optique 107 qui est générée par le présent dispositif laser.

Ainsi, il est possible de filtrer spatialement et transversalement les modes de Laguerre-Gauss transverses grâce à la combinaison de deux masques absorbants.

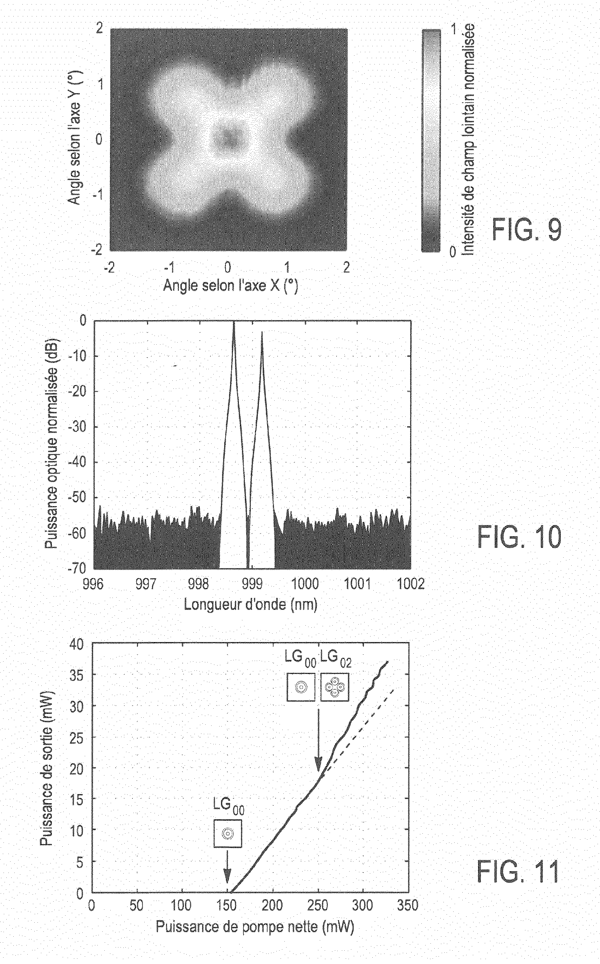

La FIGURE 9 montre une vue de l'intensité en champ lointain du laser selon l'invention, avec un masque absorbant métallique intégré. La FIGURE 9 illustre aussi la coexistence des deux modes de Laguerre-Gauss.

La FIGURE 10 illustre le spectre optique du laser selon l'invention. Elle montre que le laser selon la présente invention assure un fonctionnement bi-fréquence, illustré par les deux pics tracés et présentant une différence de fréquence entre les deux modes de 162 GHz. En changeant les motifs des masques absorbants, il est possible de modifier la fréquence de battement jusqu'à 450 GHz.

La FIGURE 11 illustre la puissance de sortie du laser en fonction de la puissance de pompage optique. Pour le premier mode transverse, au-delà d'une valeur seuil, la puissance de sortie du laser est linéaire avec une première pente jusqu'à une valeur seuil qui correspond au second mode transverse et à partir de laquelle la pente de la puissance de sortie du laser croit : le rendement du laser selon l'invention augmente lorsque le second mode apparaît. Sur l'exemple illustré sur la FIGURE 11, la valeur seuil de la puissance de pompage est, pour le premier mode, autour de 150 mW, et la valeur seuil pour le second mode est autour de 250 mW.

### Second mode de réalisation : masques de diffraction

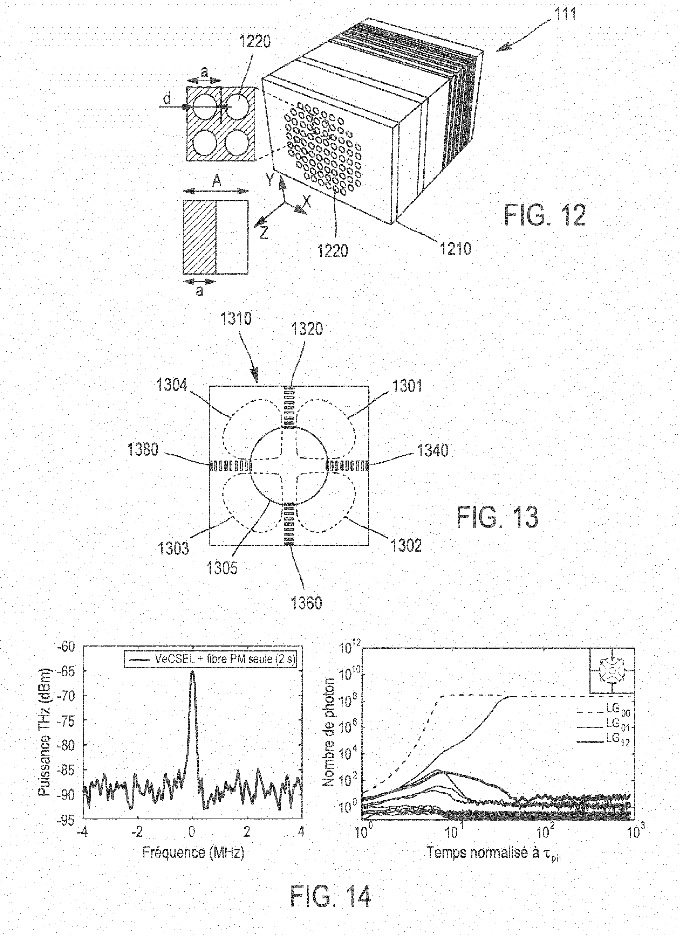

La FIGURE 12 est un dispositif laser 100 selon l'invention avec un masque diffractif sur l'élément semi-conducteur 111 conforme à la description antérieure. Il consiste en une seule couche de Si₃N₄ 1210 complétée par un réseau 2D de trous 1220 de diamètres d agencés le long d'une grille carrée de période a. Le diamètre des trous peut être constant ou variable, selon les effets recherchés. La couche unique de Si₃N₄ est un miroir à cristal photonique et déposée sur la surface du dessus du demi-VeCSEL 111, comme pour les masques absorbants. Le principe est proche de celui des masques d'absorption mais il est fondé sur des effets de diffraction au lieu des effets d'absorption. Ainsi, la lumière est diffractée afin de diffracter les modes de Laguerre-Gauss qui ne sont pas souhaités.

La FIGURE 13 illustre un autre motif de masque diffractif qui introduit des pertes sur l'onde optique 107 qui oscille à l'intérieur de la cavité laser. Le masque diffractif 1310 selon ce mode de réalisation est composé de quatre réseaux de diffraction 1320, 1340, 1360, 1380 gravés sur les deux axes de symétrie du filtre spatial 1310. Dans l'exemple illustré, le pas est de 1 µm et la taille de chaque marque est de 200 nm. Deux modes sont sélectionnés grâce à ce masque de type cristal photonique diffractif : le mode principal TEMoo 1305 représenté par une ligne circulaire centrée sur le masque et le mode LG₀₂ représenté par une courbe concave et fermée (1301 à 1304) à chaque coin du masque.

L'épaisseur typique du dépôt diélectrique sur lequel les structures diffractives sont gravées est comprise entre environ la moitié de la longueur d'onde et le huitième de la longueur d'onde.

Les masques diffractifs peuvent être fabriqués par certaines techniques microélectroniques, comme pour les masques absorbants.

### Troisième mode de réalisation : dispositif de pompage par faisceau laser structuré transversalement en intensité

Dans ce mode de réalisation particulier, la mise en forme de l'intensité de l'onde optique 107 qui résonne à l'intérieur de la cavité laser n'est plus réalisée par un masque d'absorption ; elle est désormais réalisée par pompage optique.

Dans les deux modes de réalisation précédemment exposés, le pompage optique est tout à fait homogène sur la zone correspondant au faisceau souhaitée - profil de type soit gaussien soit haut-de-forme - sur la surface active de l'élément semi-conducteur sur lequel le pompage est réalisé.

On montre avec la présente invention qu'un résultat équivalent à celui fourni par les filtres spatiaux peut être obtenu avec un modèle de pompage non homogène.

Le filtre transversal spatial est monté sur les composants optiques qui focalisent le faisceau laser de pompage 110 sur la surface active de l'élément semi-conducteur, afin de diminuer son intensité dans certaines zones, dénommées zones d'absorption, et de permettre une transmission de la lumière dans certaines autres zones, nommées zones de transmission. La forme et l'emplacement de ces zones sur le faisceau laser de pompage 110 sont agencées pour être projetés sur la surface active sur l'élément semi-conducteur, et pour qu'elles se superposent aux modes de Laguerre-Gauss transversaux que l'on cherche à intercepter. Seuls ceux correspondant aux modes de Laguerre-Gauss transversaux que l'on cherche à sélectionner seront effectivement pompés par ce laser de pompage d'intensité non homogène.

Dans certains autres modes de réalisation de la présente invention, une autre technique de mise en forme du pompage optique peut être obtenue en focalisant deux faisceaux de pompage elliptiques (les deux ellipses étant transverses l'une par rapport à l'autre) sur la puce de semi-conducteur afin de produire une aire dite de pompage de forme semblable à celle d'un pétale.

La FIGURE 14 illustre le spectre THz du VeCSEL de Laguerre-Gauss bi-fréquence par photo-couplage et l'évolution temporelle de son intensité de mode. Elle montre la génération laser simultanée de deux ondes optiques mutuellement cohérentes (c'est-à-dire affichant un bruit de phase relatif faible) à l'intérieur d'une unique cavité VeCSEL, dans un fonctionnement à onde entretenue à 300K et à puissance modérée (35 mW).

la FIGURE 14 illustre ainsi la génération d'onde THz cohérente par photo-couplage du VeCSEL bi-fréquence Laguerre-Gauss dans une photodiode UTC, et confirme l'étude théorique de la dynamique laser, montrant l'émission simultanée des deux modes LG, en régime permanent, du VeCSEL double fréquence.

La FIGURE 15 décrit un schéma d'un filtre spectral permettant de mettre en forme le profil de phase de l'onde optique oscillant dans la cavité optique, de manière complémentaire aux moyens de sélection des au moins deux modes transverses.

Le schéma (a) illustre une cavité optique dans laquelle deux modes transverses ont été sélectionnés (moyens non représentés) et intégrant un filtre spectral afin de régler l'écart en fréquence entre les deux modes, le schéma (b) illustre une vue de face dudit filtre spectral, et le schéma (c) illustre d'une part la bande passante d'un tel filtre, pour les deux modes transverses oscillants dans la cavité optique et d'autre part le gain du milieu amplificateur.

En effet, selon un mode de réalisation particulier, le dispositif selon l'invention peut comprendre entre les deux miroirs M1 et M2 formant la cavité optique - de manière complémentaire aux moyens de sélection d'au moins deux modes transverses non représentés - un filtre spectral d'absorption et/ou un filtre spectral amplificateur 1503 agencés pour générer un déphasage entre les deux modes transverses et accorder ainsi l'écart en fréquence entre les deux modes transverses oscillants (λ1, λ2) à l'intérieur de la cavité. L'intensité des modes transverses oscillants à l'intérieur de la cavité est illustrée en 1504.

Ce filtrage peut par exemple être obtenu à l'aide d'un filtre de Lyot ou de Farby-Perot comprenant un milieu à gain et/ou un milieu de pertes. Le réglage de la cavité peut ainsi être réalisé en ajustant ledit filtre de manière à ce que chaque mode transverse oscillant λ1, λ2 traverse une longueur optique différente au travers du filtre. En d'autres termes, le filtre spectral est agencé pour présenter un indice de réfraction, voire une longueur optique transverse non uniforme de manière à générer un déphasage entre les deux modes transverses oscillants.

A titre d'exemple non limitatif, un tel filtre peut être obtenu à l'aide d'un miroir de Bragg (1-10 paires) à faible réflectivité et situé sur la structure de l'élément semi-conducteur (i.e le VCSEL par exemple). Un tel miroir peut être réalisé par des procédés bien connus de dépôts microélectronique. Un tel filtre spectral permet d'obtenir avantageusement un « réglage d'usine » de l'écart de fréquence entre les deux modes transverses oscillants.

Cependant, un tel filtre spectral peut aussi être dynamique afin de proposer un moyen de contrôle sur l'écart en fréquence entre les deux modes transverses oscillants à l'intérieur de la cavité. Il peut s'agir par exemple d'une matrice de pixels de cristaux liquides pilotables.

L'ajustement des dimensions caractéristiques d'un tel miroir permet de contrôler l'indice de réfraction « perçu » par chaque mode transverse oscillant dans la cavité ; et il est possible par exemple en augmentant l'épaisseur optique du matériau traversé par un premier mode, relativement à celle traversée par le second mode, de contrôler très précisément l'écart en fréquence désiré pour le dispositif selon l'invention. Plus particulièrement, on cherchera à modifier les valeurs d'indices de réfraction (donc d'épaisseur) de la zone centrale dudit filtre par rapport à la zone périphérique. Par exemple, il est possible de graver à la surface supérieure du miroir de Bragg une surcouche déphasante d'une épaisseur typiquement inférieure à À/2 sur l'un des modes transverses par rapport à l'autre mode transverse.

Il est aussi possible d'ajouter une structure déphasant, par exemple un cristal photonique ou un méta-matériau dont l'indice de réfraction est contrôlé spatialement par les dimensions caractéristiques d'un réseau. Par exemple, il peut s'agir d'un réseau bidimensionnel de trous dont les diamètres et la périodicité évoluent selon un profil particulier qui détermine le profil de phase des modes transverses. Il est ansi possible de réaliser « à la demande » des profils de phases particulier, et notamment continus, permettant d'obtenir des réglages très fins entre les modes.

Par ailleurs, afin de déplacer spectralement cet écart de fréquence, et comme décrit précédemment, il est possible de réaliser un chauffage non uniforme transversal de manière à modifier localement la valeur de l'indice de réfraction du matériau et de contrôler le déphasage entre les deux modes transverses et donc l'écart en fréquence.

La FIGURE 16 illustre schématiquement un mode de réalisation du dispositif selon l'invention, dans lequel un milieu à gain non uniforme permet de régler l'écart de fréquence entre les deux modes transverses sélectionnés par ledit dispositif, les moyens permettant de sélectionner les deux modes transverses n'étant pas représentés.

Le schéma (a) illustre une cavité optique intégrant un milieu à gain non uniforme, le schéma (b) illustre une vue de face dudit milieu à gain, et le schéma (c) illustre la bande passante du milieu à gain.

En effet, le dispositif selon l'invention peut comprendre entre les deux miroirs M1 et M2 formant la cavité optique au moins un milieu à gain 1601, 1602 agencé pour accorder l'écart en fréquence entre les deux modes transverses oscillants (λ1, λ2) à l'intérieur de la cavité. L'intensité des modes transverses oscillants à l'intérieur de la cavité est illustrée en 1603.

Dans le cas d'un laser semi-conducteur par exemple, un tel ajustement peut être obtenu à l'aide d'une distribution transverse non uniforme des pertes au niveau du milieu à gain, et/ou par une répartition non uniforme des porteurs de charge dans ledit milieu à gain. Ainsi, l'intensité de la longueur d'émission du gain varie transversalement et permet de régler l'écart en fréquence entre les deux modes transverses.

De manière complémentaire, le dispositif selon l'invention peut comprendre au moins un masque de pertes non uniforme transversalement entre les deux modes afin d'ajuster l'écart en fréquence entre les deux modes.

## Revendications

1. Dispositif laser (100) de génération d'une onde optique (107) comprenant au moins deux fréquences, ledit dispositif laser (100) comprenant :
- un premier élément (111) comprenant une région de gain (104) située entre une première extrémité définie par un premier miroir (103) et une seconde extrémité définie par une région de sortie,
- un second miroir (106), distinct du premier élément (111), et agencé de façon à former avec le premier miroir (103) une cavité optique incluant la région de gain (104) et un espace libre (105) entre la région de sortie et le second miroir (106),
- des moyens de pompage (120) de la région de gain (104) de façon à générer l'onde optique (107),
**caractérisé en ce que** le dispositif laser (100) comprend en outre :
- des moyens de mise en forme de l'intensité lumineuse de l'onde optique (107) agencés pour sélectionner au moins deux modes transverses de l'onde optique (107), lesdits moyens de mise en forme de l'intensité comprenant au moins un masque, chaque masque étant agencé avec une surface ayant une absorbance non uniforme, ladite surface incluant au moins une zone d'absorption et au moins une zone de transmission ; et
- des moyens de mise en forme du profil de phase longitudinal et transversal de l'onde optique (107) et agencés pour régler l'écart en fréquence entre les au moins deux modes transverses de l'onde optique (107), lesdits moyens de mise en forme du profil de phase comprenant au moins un cristal photonique et/ou un réseau de diffraction situés à au moins une extrémité de la région de gain (104) et agencés pour mettre en forme la phase transversale et l'intensité transversale de l'onde optique (107).

2. Dispositif selon l'une quelconque des revendications précédentes, dans lequel chaque masque est une couche d'épaisseur nanométrique.

3. Dispositif selon l'une quelconque des revendications précédentes, dans lequel la zone d'absorption fournit une absorbance au moins deux fois plus élevée que l'absorbance de la zone de transmission.

4. Dispositif selon l'une quelconque des revendications précédentes, dans lequel chaque masque est situé au niveau d'un ventre de l'onde optique (107) à l'intérieur de la cavité.

5. Dispositif selon l'une quelconque des revendications précédentes, **caractérisé en ce que** le moyen de mise en forme du profil de phase comprend un filtre spectral présentant une longueur optique non uniforme le long de sa section transverse afin de régler l'écart en fréquence entre les deux modes transverses de ladite onde optique (107).

6. Dispositif selon la revendication précédente, **caractérisé en ce que** le filtre spectral comprend un réseau bidimensionnel de micro-gravures dont les dimensions caractéristiques, telles que le diamètre et la périodicité de leur répétition, sont ajustées de manière à générer un profil transverse prédéterminé de longueur optique du filtre et un déphasage de chaque mode transverse, et permettre ainsi de fixer la valeur d'un écart en fréquence entre lesdits deux modes transverses.

7. Dispositif selon la revendication précédente, **caractérisé en ce que** le filtre spectral comprend aussi une moyen dynamique pour contrôler le profil transverse de la longueur optique dudit filtre spectral, tel que par exemple une matrice de pixels de cristaux liquides pilotables.

8. Dispositif selon la revendication 1, dans lequel les moyens de pompage (120) de la région de gain (104) comprennent :
- un laser à pompe (108) émettant un faisceau laser de pompage (110) ; et
- des moyens agencés pour la mise en forme spatiale de l'intensité lumineuse du faisceau laser de pompage (110), agencés pour projeter un motif d'intensité du faisceau de pompage sur la région de sortie du premier élément (111) correspondant aux au moins deux modes transverses sélectionnés de l'onde optique (107).

9. Dispositif selon l'une quelconque des revendications précédentes, dans lequel le second miroir (106) est un miroir concave ou un miroir à conjugaison de phase.

10. Dispositif selon l'une quelconque des revendications précédentes, qui comprend en outre des moyens de syntonisation de déplacement du second miroir (106) de façon à changer la longueur de la cavité optique.

11. Dispositif selon l'une quelconque des revendications précédentes, qui comprend en outre des moyens de syntonisation de la différence de fréquence entre les au moins deux modes de l'onde optique (107).

12. Dispositif selon la revendication 11, pour lequel les moyens de syntonisation de la différence de fréquence sont des moyens de syntonisation thermique agencés pour établir un gradient thermique dans la direction transversale du premier élément (111).

13. Dispositif selon la revendication 12, dans lequel les moyens de syntonisation thermique comprennent au moins l'un des composants suivants :
- au moins un élément conducteur thermique local monté transversalement sur le premier élément (111) et agencé pour conduire ou dissiper la chaleur, et/ou
- des moyens de modulation de la puissance du laser de pompage (108) afin de chauffer localement :
- la région de sortie du premier élément (111), et/ou
- les moyens de filtrage spatial, et/ou
- un faisceau laser de pompage mis en forme (110) qui accentue et/ou optimise le gradient thermique transverse aux directions de propagation de l'onde optique (107).

14. Procédé de génération d'une onde optique (107) mettant en œuvre le dispositif selon l'une quelconque des revendications 1-13.

15. Utilisation du dispositif laser (100) selon l'une quelconque des revendications 1 à 13, pour des techniques de génération d'ondes térahertz, THz, avec photomélange, dans laquelle les au moins deux modes sélectionnés sont injectés dans un guide d'onde.

## Patentansprüche

1. Laservorrichtung (100) zur Erzeugung einer optischen Welle (107), umfassend mindestens zwei Frequenzen, wobei die Laservorrichtung (100) umfasst:
- ein erstes Element (111), das ein Verstärkungsbereich (104) umfasst, welcher zwischen einem ersten durch einen ersten Spiegel (103) definierten Ende und einem zweiten durch einen Ausgangsbereich definierten Ende gelagert ist,
- einen zweiten, sich von dem ersten Element (111) unterscheidenden Spiegel (106), der derart angeordnet ist, sodass er mit dem ersten Spiegel (103) zusammen eine optische Kavität bildet, welche den Verstärkungsbereich (104) und einen freien Raum (105) zwischen dem Ausgangsbereich und dem zweiten Spiegel (106) einschließt,
- Pumpeinrichtungen (120) des Verstärkungsbereichs (104) zur Erzeugung der optischen Welle (107),
**dadurch gekennzeichnet, dass** die Laservorrichtung (100) außerdem umfasst:
- Einrichtungen zur Formgebung der Lichtintensität der optischen Welle (107), welche zur Auswahl mindestens zweier transversalen Moden der optischen Welle (107) angeordnet sind, wobei die Einrichtungen zur Formgebung der Intensität mindestens eine Maske umfassen, wobei jede Maske mit einer eine nichtgleichmäßige Absorbanz aufweisenden Fläche angeordnet ist, wobei die Fläche mindestens einen Absorptionsbereich und mindestens einen Übertragungsbereich einschließt; und
- Einrichtungen zur Formgebung des longitudinalen und transversalen Phasenprofils der optischen Welle (107), welche zur Einstellung des Frequenzabstands zwischen den mindestens zwei transversalen Moden der optischen Welle (107) angeordnet sind, wobei die Einrichtungen zur Formgebung des Phasenprofils mindestens einen photonischen Kristall und/oder ein Beugungsgitter umfassen, welche an mindestens einem Ende des Verstärkungsbereichs (104) gelagert und zur Formgebung der transversalen Phase und der transversalen Intensität der optischen Welle (107) angeordnet sind.

2. Vorrichtung nach einem der vorhergehenden Ansprüche, wobei es sich bei jeder Maske um eine nanometerdicke Schicht handelt.

3. Vorrichtung nach einem der vorhergehenden Ansprüche, wobei der Absorptionsbereich eine Absorbanz bereitstellt, welche mindestens zweimal höher als die Absorbanz des Übertragungsbereichs ist.

4. Vorrichtung nach einem der vorhergehenden Ansprüche, wobei jede Maske an einem Bauch der optischen Welle (107) innerhalb der Kavität gelagert ist.

5. Vorrichtung nach einem der vorhergehenden Ansprüche, **dadurch gekennzeichnet, dass** die Einrichtung zur Formgebung des Phasenprofils einen Spektralfilter umfasst, welcher entlang seines Querschnitts eine nicht einheitliche optische Länge aufweist, um den Frequenzabstand zwischen den zwei transversalen Moden der optischen Welle (107) einzustellen.

6. Vorrichtung nach dem vorhergehenden Anspruch, **dadurch gekennzeichnet, dass** der Spektralfilter ein zweidimensionales Netz von Mikroätzungen umfasst, deren kennzeichnende Abmessungen wie Durchmesser und Periodizität ihrer Wiederholung derart eingestellt sind, sodass ein vorbestimmtes transversales Profil der optische Länge des Filters und eine Phasenverschiebung jedes transversalen Modes erzeugt werden und somit der Wert für einen Frequenzabstand zwischen den zwei transversalen Moden festgesetzt werden kann.

7. Vorrichtung nach dem vorhergehenden Anspruch, **dadurch gekennzeichnet, dass** der Spektralfilter auch eine dynamische Einrichtung zur Kontrolle des transversalen Profils der optischen Länge des Spektralfilters umfasst, wie zum Beispiel eine Pixelmatrix von steuerbaren Flüssigkristallen.

8. Vorrichtung nach Anspruch 1, wobei die Pumpeinrichtungen (120) des Verstärkungsbereichs (104) umfassen:
- einen Pumplaser (108), welcher einen Pumplaserstrahl (110) ausgibt; und
- Einrichtungen, zur räumlichen Formgebung der Lichtintensität des Pumplaserstrahls (110) angeordnet, zur Projektion eines Intensitätsmusters des Pumpstrahls auf den Ausgangsbereich des ersten Elements (111) angeordnet, welches den mindestens zwei ausgewählten, transversalen Moden der optischen Welle (107) entspricht.

9. Vorrichtung nach einem der vorhergehenden Ansprüche, wobei der zweite Spiegel (106) ein Konkavspiegel oder ein phasenkonjugierender Spiegel ist.

10. Vorrichtung nach einem der vorhergehenden Ansprüche, die außerdem Abstimmeinrichtungen der Bewegung des zweiten Spiegels (106) zur Änderung der Länge der optischen Kavität umfasst.

11. Vorrichtung nach einem der vorhergehenden Ansprüche, die außerdem Abstimmeinrichtungen des Frequenzunterschieds zwischen den mindestens zwei Moden der optischen Welle (107) umfasst.

12. Vorrichtung nach Anspruch 11, wobei die Abstimmeinrichtungen des Frequenzunterschieds thermische Abstimmeinrichtungen sind, welche zur Festlegung eines Temperaturgradients in der Querrichtung des ersten Elements (111) angeordnet sind.

13. Vorrichtung nach Anspruch 12, wobei die thermischen Abstimmeinrichtungen mindestens einen der folgenden Bestandteile umfassen:
- mindestens ein örtliches, wärmeleitendes Element, das transversal auf dem ersten Element (111) montiert und zur Leitung oder Ableitung der Wärme angeordnet ist, und/oder
- Einrichtungen zur Modulation der Leistung des Pumplasers (108) zur örtlichen Erwärmung von:
- dem Ausgangsbereich des ersten Elements (111), und/oder
- den Spektralfiltereinrichtungen, und/oder
- einem geformten Pumplaserstrahl (110), welcher den transversalen Temperaturgradient in den Ausbreitungsrichtungen der optischen Welle (107) verstärkt und/oder optimiert.

14. Verfahren zur Erzeugung einer optischen Welle (107), das die Vorrichtung nach einem der Ansprüche 1-13 einsetzt.

15. Anwendung der Laservorrichtung (100) nach einem der Ansprüche 1 bis 13 für Techniken zur Erzeugung von Terahertzwellen, THz, mit Photomischung, wobei die mindestens zwei ausgewählten Moden in einen Wellenleiter injiziert werden.

## Claims

1. A laser device (100) for generating an optical wave (107) comprising at least two frequencies, such laser device (100) comprising:
- a first element (111) comprising a gain region (104) located between one first end defined by a first mirror (103) and a second end defined by an exit region,
- a second mirror (106), distinct from the first element (111), and arranged so as to form with the first mirror (103) an optical cavity including the gain region (104) and a gap (105) between the exit region and the second mirror (106),
- means for pumping (120) the gain region (104) so as to generate the optical wave (107),
**characterized in that** the laser device (100) further comprises:
- means for shaping the light intensity of the optical wave (107) arranged for selecting at least two transverse modes of the optical wave (107), said means for shaping the light intensity comprise at least one mask, each mask being patterned with a surface having a non-uniform absorbance, said surface including at least one absorbing area and at least one transmitting area; and
- means for shaping the longitudinal and transversal phase profile of the optical wave (107) and arranged for adjusting the frequency difference between at least two transverse modes of the optical wave (107), said means for shaping the phase profile comprise at least one photonic crystal and/or diffraction grating located at least at one end of the gain region (104) and patterned in order to shape the transverse phase and the transverse intensity of the optical wave (107).

2. The device according to any one of the preceding claims, wherein each mask is a nanometer-thick layer.

3. The device according to any one of the preceding claims, wherein the absorbing area provides an absorbance at least twice higher than the absorbance of the transmitting area.

4. The device according to any one of the preceding claims, wherein each mask is located at an anti-node value of the optical wave (107) inside the cavity.

5. The device according to any of the preceding claims, wherein the mean for shaping phase profile of the optical wave comprises a spectral filter presenting a non-uniform optical wavelength along its transvers section in order to adjust the frequency difference between the at least two transverse modes of the optical wave (107).

6. The device according to the preceding claim, wherein the spectral filter comprises a bi-dimensional micro-etching network which of the characteristic dimensions, such as the diameter and their repetition pattern, are adjusted in order to generate a predetermined transverse profile of the optical wavelength of said filter and a phase shift of each transverse mode, allowing to fix a frequency difference value between said at least two transverse modes

7. The device according to the preceding claim, wherein the spectral filter comprises furthermore a mean for dynamic control of the optical wavelength transverse profile of said spectral filter, such as a controllable crystal liquid pixel matrix.

8. The device according to claim 1, wherein the means for pumping (120) the gain region (104) comprise:
- a pump laser (108) emitting a pumping laser beam (110), and
- means arranged for spatially shaping the pumping laser beam (110) intensity, arranged to project a pumping beam intensity pattern onto the exit region of the first element (111) corresponding with the at least two selected transverse mode of the optical wave (107).

9. The device according to any one of the preceding claims, wherein the second mirror (106) is a concave mirror or a phase conjugator mirror.

10. The device according to any one of the preceding claims, which further comprises tuning means for moving the second mirror (106) so as to change the length of the optical cavity.

11. The device according to any one of the preceding claims, which further comprises means for tuning the frequency difference between the at least two modes of the optical wave (107).

12. The device according to claim 11, for which means for tuning the frequency difference are thermal tuning means arranged to establish a thermal gradient into the transverse direction of the first element (111).

13. The device according to claim 12, in which the means for thermal tuning comprises one of the following components:
- at least one local thermal conducing element transversally mounted on the first element (111) and arranged to conduct or dissipate heat, and/or
- means for modulating a pump laser (108) power in order to locally heat:
- the exit region of the first element (111), and/or
- the means for spatially filtering, and/or
- a shaped pumping laser beam (110) that enhanced and/or optimized the thermal gradient across the transverse directions of the optical wave (107) propagation.

14. **A** method for generating an optical wave (107) implementing the device according to claim 1 to 13 comprising at least two frequencies and comprising at least one of the following steps:
- generating an optical wave (107) inside a gain region (104),
- pumping the optical wave (107) with means for pumping (120),
- shaping the light intensity and/or profile of the optical wave (107) for selecting at least two transverse modes optical wave (107).

15. Utilization of the laser device (100) according to any one of claims 1 to 13 for terahertz, THz, wave generation with photomixing techniques, wherein the at least two modes selected are injected into a waveguide.
